# EUROPEAN PATENT APPLICATION

(11) **EP 4 613 490 A1**
(43) Date of publication of application: **10.09.2025**
(21) Application number: 25154072.0
(22) Date of filing: 27.01.2025
(51) Int. Cl.: B41J 2/16, B41J 2/14

(54) **METHOD OF MANUFACTURING INKJET HEAD, INKJET HEAD MANUFACTURED THEREBY, AND METHOD OF INSPECTING INKJET HEAD**

(30) Priority: 05.03.2024 KR 20240031626
(71) Applicant: Samsung Display Co., Ltd., Yongin-si, Gyeonggi-do 17113 (KR)
(72) Inventor: KIM, Jaesik, Yongin-si (KR); SEO, Junghan, Yongin-si (KR); SUNG, Woo Yong, Yongin-si (KR); YOON, Kwanhyuck, Yongin-si (KR); YOON, Seungho, Yongin-si (KR); LEE, Byeongjun, Yongin-si (KR); LEE, Hyemin, Yongin-si (KR); CHAE, Seunggun, Yongin-si (KR)
(74) Representative: Marks & Clerk LLP

(57) **Abstract**

A method of manufacturing an inkjet head, the method includes forming a preliminary nozzle plate including an organic material, forming a nozzle plate including a plurality of nozzles formed by processing the preliminary nozzle plate using a laser, forming a piezoelectric plate on the nozzle plate, forming a first coating film on a lower surface of the nozzle plate, forming a second coating film covering the first coating film and including a material different from the first coating film, forming a third coating film under the second coating film and including a material different from the first and second coating films, and forming a fourth coating film under the third coating film and including a material different from the first, second, and third coating films.

## Description

### BACKGROUND

### 1. Technical Field

Embodiments provide generally to a method of manufacturing an inkjet head, the inkjet head manufactured thereby, and a method of inspecting the inkjet head. More particularly, embodiments relate to the method of manufacturing the inkjet head used in a process of manufacturing a display device, the inkjet head manufactured thereby, and the method of inspecting the inkjet head.

### 2. Description of the Related Art

As information technology develops, the importance of display devices, which are communication media between users and information, is being highlighted. Accordingly, the use of display devices such as a liquid crystal display device, an organic light emitting display device, a plasma display device, and the like is increasing.

An inkj et printing apparatus may be used in a manufacturing process of a display device. For example, in case that manufacturing the display device such as an organic light emitting display device, the inkjet printing apparatus may be used to form patterns such as a color conversion layer, a light emitting layer, and the like.

The inkjet printing apparatus may include a plurality of inkjet heads that eject ink.

### SUMMARY

Embodiments provide a method of manufacturing an inkjet head with improved wear resistance.

Embodiments provide the inkjet head manufactured through the method of manufacturing the inkjet head.

Embodiments provide the method of inspecting the inkjet head.

The inkjet head may be coated with a plurality of coating films to improve ejection precision and protect the nozzles of the inkjet head.

However, embodiments are not limited to those set forth herein. The above and other embodiments will become more apparent to one of ordinary skill in the art to which the disclosure pertains by referencing the detailed description of the disclosure given below.

A method of manufacturing an inkjet head according to embodiments, the method includes forming a preliminary nozzle plate including an organic material, forming a nozzle plate including a plurality of nozzles formed by processing the preliminary nozzle plate using a laser, forming a piezoelectric plate on the nozzle plate, forming a first coating film on a lower surface of the nozzle plate, forming a second coating film covering the first coating film and including a material different from the first coating film, forming a third coating film including a material different from the first and second coating films and disposed under the second coating film, and forming a fourth coating film including a material different from the first, second, and third coating films and disposed under the third coating film.

In an embodiment, in the forming of the first coating film, the first coating film may be formed to entirely cover an inner surface of the nozzle plate exposed by each of the nozzles.

In an embodiment, in the forming of the second coating film, the second coating film may be formed to entirely cover a side surface of the piezoelectric plate.

In an embodiment, the first coating film may include an organic material and an inorganic material, the second coating film may include at least one of a metal oxide and an organic-inorganic composite material including the metal oxide, the third coating film may include an inorganic material, and the fourth coating film may include a polymer compound having hydrophobic characteristics and including fluorine (F) and silicon (Si).

In an embodiment, the preliminary nozzle plate may include polyimide (PI).

In an embodiment, the forming of the piezoelectric plate may include forming a first polymer layer on the nozzle plate, forming an organic layer on the first polymer layer, forming a piezoelectric member on the organic layer, forming a metal layer on the piezoelectric member, forming a glass layer on the metal layer, and forming a second polymer layer on the glass layer and the organic layer.

A method of manufacturing an inkjet head according to embodiments, the method includes forming a preliminary nozzle plate including an organic material, forming a preliminary first-first coating film on a lower surface of the preliminary nozzle plate, forming a preliminary sacrificial coating film including a material different from the preliminary first-first coating film on a lower surface of the preliminary first-first coating film, forming a nozzle plate including a plurality of nozzles, a first-first coating film forming a step with the nozzle plate, and a sacrificial coating film forming a step with the nozzle plate by processing the preliminary nozzle plate, the preliminary first-first coating film, and the preliminary sacrificial coating film using a laser, forming a piezoelectric plate on the nozzle plate, removing the sacrificial coating film, forming a first-second coating film covering the first-first coating film on a lower surface of the first-first coating film, forming a second coating film covering the first-second coating film and including a material different from the first-first and first-second coating films, forming a third coating film including a material different from the first-second and second coating films under the second coating film, and forming a fourth coating film including a material different from the first-second, second, and third coating films under the third coating film.

In an embodiment, in the forming of the first-second coating film, the first-second coating film may be formed to entirely cover an inner surface of the nozzle plate exposed by each of the nozzles.

In an embodiment, in the forming of the second coating film, the second coating film may be formed to entirely cover a side surface of the piezoelectric plate.

In an embodiment, the first-first coating film and the first-second coating film may include an organic material and an inorganic material, the second coating film may include at least one of a metal oxide and an organic-inorganic composite material including the metal oxide, the third coating film may include an inorganic material, and the fourth coating film may include a polymer compound having hydrophobic characteristics and including fluorine (F) and silicon (Si).

In an embodiment, the preliminary nozzle plate may include polyimide (PI).

In an embodiment, the forming of the piezoelectric plate may include forming a first polymer layer on the nozzle plate, forming an organic layer on the first polymer layer, forming a piezoelectric member on the organic layer, forming a metal layer on the piezoelectric member, forming a glass layer on the metal layer, and forming a second polymer layer on the glass layer and the organic layer.

An inkjet head according to embodiments includes a nozzle plate including an organic material and including a plurality of nozzles that discharge an ink to an outside, a piezoelectric plate disposed on the nozzle plate, a first coating film disposed on a lower surface of the nozzle plate and an inner surface of the nozzle plate exposed by each of the nozzles, a second coating film covering the first coating film and including a material different from the first coating film, a third coating film disposed under the second coating film, covering at least a portion of the second coating film, and including a material different from the first and second coating films, and a fourth coating film disposed under the third coating film and including a material different from the first, second, and third coating films.

In an embodiment, the first coating film may entirely cover the inner surface of the nozzle plate.

In an embodiment, a first thickness of a portion of the first coating film contacting the lower surface of the nozzle plate may be thicker than a second thickness of a portion of the first coating film contacting the inner surface of the nozzle plate.

In an embodiment, the second coating film may extend from under the first coating film to entirely cover a side surface of the piezoelectric plate.

In an embodiment, the third coating film may extend from under the second coating film to at least a portion of an inside of the nozzles.

In an embodiment, the inner surface of the nozzle plate may include a first side surface perpendicular to the lower surface of the nozzle plate and a second side surface inclined in a direction away from each of the nozzles, and the third coating film may extend from under the second coating film to an inside of the nozzles to face the first side surface of the inner surface of the nozzle plate.

In an embodiment, the first coating films may include a first-first coating film disposed on the lower surface of the nozzle plate and forming a step together with the nozzles plate and a first-second coating film disposed on a lower surface of the first-first coating film and the inner surface of the nozzle plate to cover the first-first coating film.

In an embodiment, a first thickness of a portion of the first coating film contacting the lower surface of the nozzle plate may be thicker than a second thickness of a portion of the first coating film contacting the inner surface of the nozzle plate.

In an embodiment, an average thickness of the first coating film may be in a range of about 5 nm to about 25 nm, an average thickness of the second coating film may be in a range of about 5 nm to about 1000 nm, and an average thickness of the third coating film may be in a range of about 5 nm to about 1000 nm.

In an embodiment, an average thickness of the fourth coating film may be in a range of about 20 nm or less.

In an embodiment, the first coating film may include an organic material and an inorganic material, the second coating film may include at least one of a metal oxide and an organic-inorganic composite material including the metal oxide, the third coating film may include an inorganic material, and the fourth coating film may include a polymer compound having hydrophobic characteristics and including fluorine (F) and silicon (Si).

In an embodiment, the nozzle plate may include polyimide (PI).

In an embodiment, the piezoelectric plate may include a first polymer layer disposed on the nozzle plate, an organic layer disposed on the first polymer layer, a piezoelectric member disposed on the organic layer, a metal layer disposed on the piezoelectric member, a glass layer disposed on the metal layer, and a second polymer layer disposed on the glass layer and the organic layer.

In an embodiment, in case that the ink is disposed inside the inkjet head, a brightness ratio of a first area of the inkjet head where each of the nozzles is disposed in a second area of the inkjet head excluding the nozzles may be about 1 or less.

A method of inspecting an inkjet head according to embodiments includes manufacturing the inkjet head including: a nozzle plate including an organic material and including a plurality of nozzles that discharge an ink to an outside, a piezoelectric plate formed on the nozzle plate, a first coating film formed on a lower surface of the nozzle plate, a second coating film covering the first coating film and including a material different from the first coating film, a third coating film formed under the second coating film, covering at least a portion of the second coating film, and including an inorganic material, and a fourth coating film formed under the third coating film and including a material different from the first, second, and third coating films, and imaging the inkjet head as a two dimensional (2D) image in case that the ink is disposed inside the inkjet head.

In an embodiment, the imaging of the inkjet head as the 2D image in case that the ink is disposed inside the inkjet head may include measuring an amount of gray level change between a first area of the inkjet head where each of the nozzles is disposed and a second area of the inkjet head excluding the nozzles.

In an embodiment, in case that the ink is disposed inside the inkjet head, a brightness ratio of a first area of the inkjet head where each of the nozzles is disposed in a second area of the inkjet head excluding the nozzles may be about 1 or less.

In an embodiment, in the imaging of the inkjet head as the 2D image in case that the ink is disposed inside the inkjet head, the inkjet head may be imaged using a microscope in reflection mode or transmission mode.

In an inkjet head according to embodiments, a nozzle part of the inkjet head may include a nozzle plate including an organic material, a first coating film disposed on a lower surface of the nozzle plate and an inner surface of the nozzle plate exposed by each of the nozzles, a second coating film covering the first coating film, a third coating film disposed under the second coating film and covering at least a portion of the second coating film, and a fourth coating film disposed under the third coating film. The first coating film may include an inorganic material and an organic material, the second coating film may include a metal oxide, the third coating film may include an inorganic material, and the fourth coating film may have liquid repellency. Accordingly, the occurrence of scratches, tears, and the like in the first coating film may be reduced. For example, deterioration in the ink discharge characteristics of the inkjet head may be reduced, and the wear resistance of the inkjet head may be improved.

In a method of manufacturing the inkjet head according to embodiments, before forming the first, second, third, and fourth coating films, a nozzle plate including a plurality of nozzles may be formed by processing a preliminary nozzle plate using a laser. In another example, after forming the nozzle plate, a first-first coating film on the lower surface of the nozzle plate, a sacrificial coating film having liquid repellency on a lower surface of the first-first coating film, and a piezoelectric plate on the nozzle plate, the sacrificial coating film may be removed. After the sacrificial coating film is removed, a first-second coating film, a third coating film, and a fourth coating film may be formed sequentially. Accordingly, a first coating film formed as the first-first coating film and the first-second coating film may be formed on the inner surface of the nozzle plate, and the inkjet head with improved wear resistance may be manufactured.

At least some of the above and other features of the invention are set out in the claims.

### BRIEF DESCRIPTION OF THE DRAWINGS

Illustrative, non-limiting embodiments will be more clearly understood from the following detailed description in conjunction with the accompanying drawings.
FIG. 1 is a schematic perspective view illustrating an inkjet printing apparatus according to embodiments.
FIG. 2 is a schematic perspective view illustrating a head module of FIG. 1.
FIG. 3 is a schematic perspective view illustrating one inkjet head included in the head module of FIG. 2.
FIG. 4 is a schematic plan view illustrating a nozzle part included in the inkjet head of FIG. 3.
FIG. 5 is a schematic cross-sectional view illustrating an example of a cross-section taken along line I-I' of FIG. 3.
FIGS. 6, 7, 8, 9, 10, 11, and 12 are schematic cross-sectional views for explaining a method of manufacturing the inkjet head of FIG. 5.
FIG. 13 is a schematic cross-sectional view illustrating another example of a cross-section taken along line I-I' of FIG. 3.
FIGS. 14, 15, 16, 17, 18, 19, 20, and 21 are schematic cross-sectional views for explaining a method of manufacturing the inkjet head of FIG. 13.
FIG. 22 is a schematic cross-sectional view illustrating still another example of a cross-section taken along line I-I' of FIG. 3.
FIG. 23 is a flowchart illustrating a method of inspection the inkjet head according to embodiments.

### DETAILED DESCRIPTION OF THE EMBODIMENTS

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z - axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Hereinafter, a method of manufacturing an inkjet head, the inkjet head manufactured thereby, and a method of inspecting the inkjet head according to embodiments will be explained in detail with reference to the accompanying drawings. The same reference numerals are used for the same components in the drawings, and redundant descriptions of the same components will be omitted.

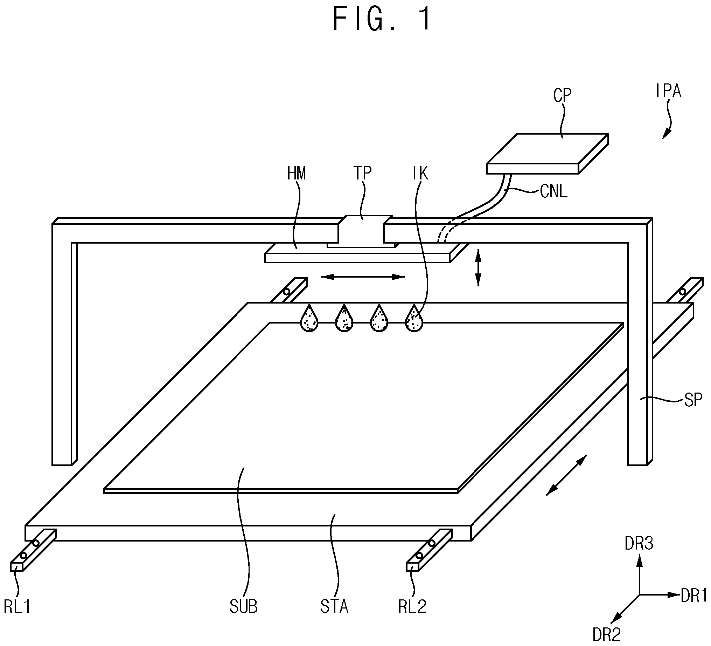

FIG. 1 is a schematic perspective view illustrating an inkjet printing apparatus according to embodiments.

In this specification, a plane may be defined as a first direction DR1 and a second direction DR2 crossing the first direction DR1. For example, the second direction DR2 may be perpendicular to the first direction DR1. For example, a third direction DR3 may be perpendicular to the plane.

Referring to FIG. 1, an inkjet printing apparatus IPA according to embodiments may include a head module HM, a stage STA, a first guide rail RL1, a second guide rail RL2, a moving part TP, a control part CP, and support part SP.

The head module HM may discharge an ink IK to the outside. For example, the head module HM may discharge the ink IK on a substrate SUB disposed on the stage STA. For example, as the head module HM discharges ink IK on the substrate SUB, a color conversion layer or a light emitting layer of a display device may be formed on the substrate SUB. However, embodiments are not limited thereto.

As described above, the substrate SUB may be disposed on the stage STA. The stage STA may move in the second direction DR2 by the first guide rail RL1 connected to a side of the stage STA and the second guide rail RL2 connected to another side of the stage STA. Accordingly, the substrate SUB may also move in the second direction DR2 by the first guide rail RL1 and the second guide rail RL2. For example, the ink IK discharged from the head module HM may be applied to a selected location on the substrate SUB. For example, each of the first guide rail RL1 and the second guide rail RL2 may extend in the second direction DR2.

The moving part TP may be combined with (or coupled to) the head module HM. The moving part TP may move the head module HM in a specific direction. For example, the moving part TP may move the head module HM in the first direction DR1, in a direction opposite to the first direction DR1, in the third direction DR3, or in a direction opposite to the third direction DR3. As the moving part TP moves the head module HM in the specific direction, the position where the ink IK is discharged on the substrate SUB may be specified or controlled.

The control part CP may be connected to the head module HM. The control part CP may include an ink supply module and an ink control module. The ink supply module of the control part CP may supply the ink IK to the head module HM through a connector CNL. The ink control module of the control part CP may control the head module HM by providing an electrical signal to the head module HM. Accordingly, the ink control module of the control part CP may adjust the time and position of discharging the ink IK on the substrate SUB.

The support part SP may fix the head module HM and the moving part TP to be positioned on the stage STA. The moving part TP may move along a portion of the support part SP in the first direction DR1 or in a direction opposite to the first direction DR1. Accordingly, the head module HM coupled to the moving part TP may move along the portion of the support part SP in the first direction DR1 or in the direction opposite to the first direction DR1.

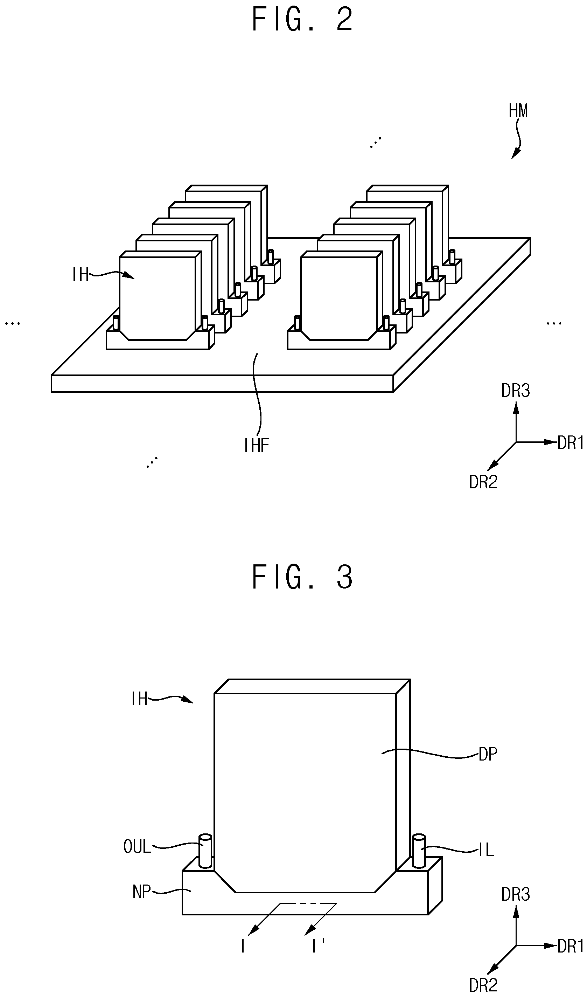

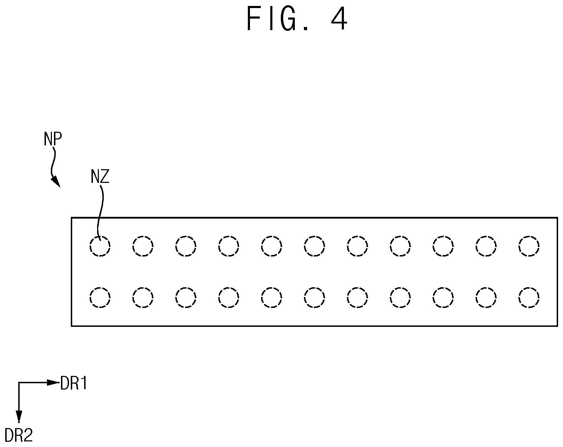

FIG. 2 is a schematic perspective view illustrating a head module of FIG. 1. FIG. 3 is a schematic perspective view illustrating an inkjet head (e.g., single inkjet head) included in the head module of FIG. 2. FIG. 4 is a schematic plan view illustrating a nozzle part included in the inkjet head of FIG. 3.

Referring to FIGS. 1, 2, and 3, the head module HM may include an inkjet head frame IHF and inkjet heads IH.

The inkjet head frame IHF may support the inkjet heads IH at lower portions of the inkjet heads IH. For example, the inkjet head frame IHF may serve (or function) as a frame for the inkjet heads IH. For example, the inkjet heads IH may be inserted into and fixed to the inkjet head frame IHF. For example, openings may be defined (or formed) in the inkjet head frame IHF, and the inkjet heads IH may be inserted into and fixed to the openings, respectively.

The inkjet head frame IHF may have various shapes. For example, the inkjet head frame IHF may have a square pillar shape. However, embodiments are not limited thereto.

The head module HM may discharge the ink IK to the outside through the inkjet heads IH. The inkjet heads IH may be disposed on the inkjet head frame IHF. The inkjet heads IH may be repeatedly arranged along the first direction DR1 and the second direction DR2 on the inkjet head frame IHF. The inkjet heads IH may constitute a head pack. For example, one head pack may be constituted by forming a set of five inkjet heads IH adjacent to each other in the second direction DR2. However, embodiments are not limited to this, and the number of inkjet heads IH constituting one head pack may vary.

Each of the inkjet heads IH may include a nozzle part NP, a driving part DP, an inlet IL, and an outlet OUL.

Nozzles NZ may be defined (or formed) in the nozzle part NP. The nozzles NZ may be repeatedly arranged along the first direction DR1 and the second direction DR2. The nozzles NZ may each be formed to penetrate a nozzle plate of the nozzle part NP. The inkjet head IH may discharge ink to the outside (e.g., the substrate SUB of FIG. 1) through the nozzles NZ of the nozzle part NP.

The inlet IL and the outlet OUL may be disposed on the nozzle part NP. The inlet IL and the outlet OUL may be arranged to be spaced apart from each other in the first direction DR1 with the driving part DP interposed therebetween. For example, the inlet IL may be connected to one side of the nozzle part NP, and the outlet OUL may be connected to the other side of the nozzle part NP. The ink IK may flow in (or be injected) through the inlet IL. For example, the ink IK may be discharged to the outside (e.g., the substrate SUB of FIG. 1) through the nozzles NZ of the nozzle part NP using the ink IK flowing in through the inlet IL. Among the ink IK present (or disposed) in the nozzles NZ of the nozzle part NP, the ink IK that is not discharged to the outside may be recovered through the outlet OUL.

The driving part DP may be disposed on the nozzle part NP. The driving part DP may be disposed between the inlet IL and the outlet OUL. For example, the driving part DP may be inserted into and fixed to the nozzle part NP. For example, the driving part DP may include various electronic components (e.g., a printed circuit board) for driving the nozzle part NP.

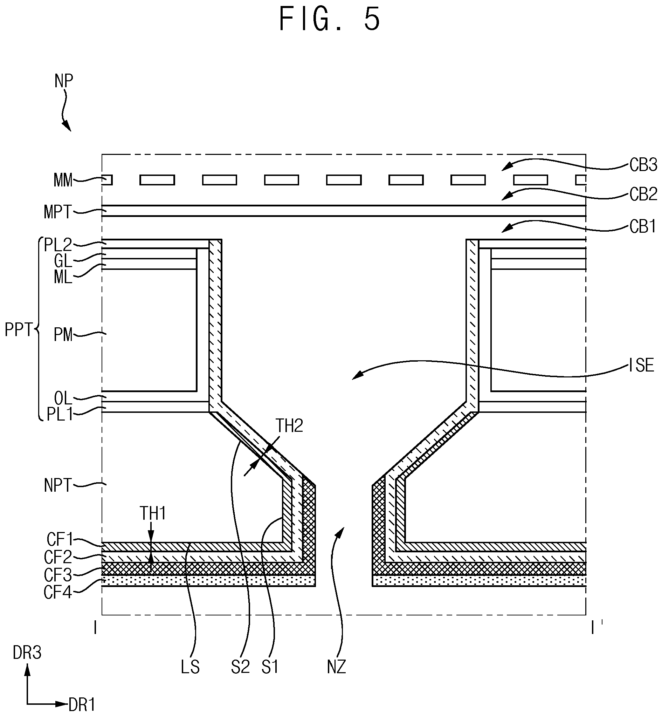

FIG. 5 is a schematic cross-sectional view illustrating an example of a cross-section taken along line I-I' of FIG. 3.

Referring to FIGS. 3 and 5, the nozzle part NP of the inkjet head IH may include a nozzle plate NPT, first, second, third, and fourth coating films CF1, CF2, CF3, and CF4, a piezoelectric plate PPT, a metal plate MPT, and a metal mesh MM. For example, the piezoelectric plate PPT may include a first polymer layer PL1, an organic layer OL, a piezoelectric member PM, a metal layer ML, a glass layer GL, and a second polymer layer PL2.

In an embodiment, the nozzle plate NPT may include an organic material. For example, the nozzle plate NPT may include polyimide (PI). However, embodiments are not limited thereto.

The nozzle NZ through which the ink (e.g., the ink IK of FIG. 1) is discharged to the outside may be defined (or formed) in the nozzle plate NPT. The nozzle NZ may be formed to penetrate the nozzle plate NPT. For example, the nozzle NZ may be formed by penetrating the nozzle plate NPT in the third direction DR3.

The nozzle plate NPT may include an outer surface and an inner surface. The outer surface of the nozzle plate NPT may be a lower surface LS of the nozzle plate NPT facing the first, second, third, and fourth coating films CF1, CF2, CF3, and CF4. The inner surface of the nozzle plate NPT may be exposed by the nozzle NZ. The inner surface of the nozzle plate NPT may include a first side surface S1 and a second side surface S2. The first side surface S1 may connect the lower surface LS of the nozzle plate NPT and the second side surface S2. In an embodiment, the first side surface S1 may be perpendicular to the lower surface LS of the nozzle plate NPT, and the second side surface S2 may be inclined in a direction away from the nozzle NZ.

A diameter of the nozzle NZ may vary according to the location (or position). In an embodiment, the diameter of the nozzle NZ contacting the first side surface S1 may be smaller than the diameter (or average diameter) of the nozzle NZ contacting the second side surface S2. However, embodiments are not limited thereto.

The piezoelectric plate PPT may be disposed on the nozzle plate NPT. For example, the first polymer layer PL1 may be disposed on the nozzle plate NPT. The first polymer layer PL1 may include an adhesive material. For example, the first polymer layer PL1 may include an adhesive material such as an epoxy-based resin, silicone-based resin, and the like. These can be used alone or in combination with each other.

The organic layer OL may be disposed on the first polymer layer PL1. The organic layer OL and the nozzle plate NPT may be combined through the first polymer layer PL1. The organic layer OL may include a polymer compound. For example, the organic layer OL may include parylene. However, embodiments are not limited thereto. The organic layer OL may cover the lower and side surfaces of the piezoelectric member PM. For example, the organic layer OL may contact the lower and side surfaces of the piezoelectric member PM. Accordingly, the organic layer OL may reduce damage occurring in the piezoelectric member PM.

The piezoelectric member PM may be disposed on the first polymer layer PL1 and the organic layer OL. The piezoelectric member PM may control the flow of the ink supplied to the nozzle NZ during the ink discharge process. For example, an electrical signal generated from a control part (e.g., the control part CP of FIG. 1) may be transmitted to the piezoelectric plate PPT to generate vibration. Pressure may be generated inside the nozzle part NP from the vibration, thereby controlling the flow rate of the ink.

For example, the piezoelectric member PM may adjust the pressure outside and inside the nozzle part NP. The piezoelectric member PM may adjust the external pressure and the pressure of a first ink chamber CB1 to be the same or different. For example, the piezoelectric member PM may adjust the pressure of the first ink chamber CB1 to be higher than the external pressure. Accordingly, the ink inside the first ink chamber CB1 may be discharged to the outside through the nozzle NZ. In another example, the piezoelectric member PM may adjust the external pressure and the pressure of the first ink chamber CB1 to be substantially equal. Accordingly, the ink inside the first ink chamber CB1 may not be discharged to the outside through the nozzle NZ.

The piezoelectric member PM may include a piezoelectric material. For example, the piezoelectric member PM may include a piezoelectric material such as lead zirconate titanate (PZT). However, embodiments are not limited thereto.

The metal layer ML may be disposed on the piezoelectric member PM. The metal layer ML may contact an upper surface of the piezoelectric member PM and a portion of the organic layer OL. The metal layer ML may protect the piezoelectric member PM. For example, the metal layer ML may include aluminum (Al). However, embodiments are not limited thereto.

The glass layer GL may be disposed on the metal layer ML. The glass layer GL may contact the upper surface of the metal layer ML and a portion of the organic layer OL. For example, the glass layer GL may include glass, quartz, and the like. These can be used alone or in combination with each other.

The second polymer layer PL2 may be disposed on the glass layer GL and the organic layer OL. A lower surface of the second polymer layer PL2 may contact an upper surface of the glass layer GL and a portion of the organic layer OL. The second polymer layer PL2 may include an adhesive material. For example, the second polymer layer PL2 may include an adhesive material such as an epoxy-based resin, silicone-based resin, and the like. These can be used alone or in combination with each other.

Accordingly, the piezoelectric plate PPT including the first polymer layer PL1, the organic layer OL, the piezoelectric member PM, the metal layer ML, the glass layer GL, and the second polymer layer PL2 may be disposed on the nozzle plate NPT.

An ink supply passage ISE may be defined (or formed) in the piezoelectric plate PPT. The ink supply passage ISE may be formed by penetrating the piezoelectric plate PPT. The ink supply passage ISE may be connected to the nozzle NZ. For example, the ink supply passage ISE may expose the nozzle NZ. The ink supply passage ISE may be a passage through which the ink passes. Accordingly, the ink may be transferred to the nozzle NZ through the ink supply passage ISE.

The metal plate MPT may be disposed on the piezoelectric plate PPT. The metal plate MPT may include a metal material. For example, the metal plate MPT may include stainless steel (SUS). However, embodiments are not limited thereto.

The first ink chamber CB1 may be defined (or formed) between the piezoelectric plate PPT and the metal plate MPT. The first ink chamber CB1 may be connected to the ink supply passage ISE. For example, the first ink chamber CB1 may expose the ink supply passage ISE. The ink may be stored inside the first ink chamber CB1. The first ink chamber CB1 may transfer the ink to the ink supply passage ISE. For example, in case that the pressure of outside the inkjet head IH and the pressure of the first ink chamber CB1 are substantially the same, the ink may be stored inside the first ink chamber CB1. For example, the ink may not be discharged from the first ink chamber CB1 through the ink supply passage ISE to the outside through the nozzle NZ.

The metal mesh MM may be disposed on the metal plate MPT. The metal mesh MM may have a mesh shape in the plan view. The metal mesh MM may include a metal material. For example, the metal mesh MM may include stainless steel. However, embodiments are not limited thereto.

A second ink chamber CB2 may be defined (or formed) between the metal plate MPT and the metal mesh MM. The ink may be stored inside the second ink chamber CB2. The second ink chamber CB2 may transfer the ink to the first ink chamber CB1. The first ink chamber CB1 and the second ink chamber CB2 may be connected to each other through a connection passage in an area different from an area of the nozzle part NP illustrated in FIG. 5. For example, the second ink chamber CB2 may expose the first ink chamber CB1.

A third ink chamber CB3 may be defined (or formed) on the metal mesh MM. The ink may be stored inside the third ink chamber CB3. The third ink chamber CB3 may transfer the ink to the second ink chamber CB2. The third ink chamber CB3 and the second ink chamber CB2 may be connected to each other through a connection passage. For example, the third ink chamber CB3 may expose the second ink chamber CB2. Accordingly, the ink may sequentially pass from the third ink chamber CB3 through the first and second ink chambers CB1 and CB2 and be transferred to the ink supply passage ISE.

As a result, the ink supply passage ISE, the first ink chamber CB1, the metal plate MPT, the second ink chamber CB2, the metal mesh MM, and the third ink chamber CB3 may form an ink channel. The ink channel may control the flow rate of the ink to discharge the ink to the outside.

The first coating film CF1 may be disposed on the lower surface LS of the nozzle plate NPT. The first coating film CF1 may serve (or function) to bond the nozzle plate NPT and the second coating film CF2. For example, the wear resistance of the inkjet head IH may be improved due to the first coating film CF1.

The first coating film CF1 may extend from the lower surface LS of the nozzle plate NPT to at least a portion of the inside of the nozzle NZ. In an embodiment, the first coating film CF1 may extend from the lower surface LS of the nozzle plate NPT to cover the inner surface of the nozzle plate NPT. For example, the first coating film CF1 may cover (e.g., entirely cover) the inner surface of the nozzle plate NPT. For example, the first coating film CF1 may contact the lower surface LS of the nozzle plate NPT and the inner surface. For example, a step may not be formed between the first coating film CF1 and the nozzle plate NPT. As the first coating film CF1 covers the inner surface of the nozzle plate NPT, the occurrence of scratches and tears in the first coating film CF1 may be reduced.

In an embodiment, the first coating film CF1 may include an organic material and an inorganic material. For example, the first coating film CF1 may include silicon oxycarbide (SiOC). However, embodiments are not limited thereto.

For example, the average thickness of the first coating film CF1 may be in a range of about 5 nm to about 25 nm. However, embodiments are not limited thereto. For example, a first thickness TH1 of a portion of the first coating film CF1 contacting the lower surface LS of the nozzle plate NPT may be different from a second thickness TH2 of a portion of the first coating film CF1 contacting the inner surface of the nozzle plate NPT. In an embodiment, the first thickness TH1 of the portion of the first coating film CF1 contacting the lower surface LS of the nozzle plate NPT may be thicker than the second thickness TH2 of the portion of the first coating film CF1 contacting the inner surface of the nozzle plate NPT.

The second coating film CF2 may be disposed under the first coating film CF1. The second coating film CF2 may extend from under the first coating film CF1 to cover at least a portion of the side surface of the piezoelectric plate PPT. In an embodiment, the second coating film CF2 may cover (e.g., entirely cover) the side surface of the piezoelectric plate PPT. For example, the second coating film CF2 may contact (e.g., entirely contact) the first coating film CF1 and may contact the side surface of the piezoelectric plate PPT.

The second coating film CF2 may include a different material from the first coating film CF1. In an embodiment, the second coating film CF2 may include metal oxide. In another embodiment, the second coating film CF2 may include a metal oxide and/or an organic-inorganic composite material including a metal oxide. Examples of the metal oxide may include aluminum oxide (e.g., Al₂O₃), silicon tin oxide (SiSnOₓ), and the like. Examples of the organic material may include alkanes (CₓH_{y}).

For example, an average thickness of the second coating film CF2 may be in a range of about 5 nm to about 1000 nm. However, embodiments are not limited thereto. The second coating film CF2 may extend from under the first coating film CF1 to the side surface of the piezoelectric plate PPT with substantially the same (or similar) thickness.

The third coating film CF3 may be disposed under the second coating film CF2. The third coating film CF3 may cover at least a portion of the second coating film CF2. The third coating film CF3 may serve (or function) to bond the second coating film CF2 and the fourth coating film CF4.

The third coating film CF3 may extend from under the second coating film CF2 to at least a portion of the inside of the nozzle NZ. In an embodiment, the third coating film CF3 may extend from under the second coating film CF2 to the inside of the nozzle NZ to face the first side surface S1 of the inner surface of the nozzle plate NPT. For example, the third coating film CF3 may contact a portion of the second coating film CF2. However, embodiments are not limited thereto. In another embodiment, the third coating film CF3 may extend to cover (e.g., entirely cover) the second coating film CF2. For example, the third coating film CF3 may contact (e.g., entirely contact) the second coating film CF2.

The third coating film CF3 may include a different material from the first and second coating films CF1 and CF2. In an embodiment, the third coating film CF3 may include an inorganic material. For example, the third coating film CF3 may include silicon oxide (e.g., SiO₂). In another example, the third coating film CF3 may include silicon nitride (SiNₓ), silicon oxynitride (SiNₓO_{y}), metal oxide, and the like. These can be used alone or in combination with each other.

For example, an average thickness of the third coating film CF3 may be in a range of about 5 nm to about 1000 nm. However, embodiments are not limited thereto. In case that the average thickness of the third coating film CF3 exceeds about 1000 nm, the ink discharge characteristics of the nozzle NZ may deteriorate. The third coating film CF3 may extend from under the second coating film CF2 to at least a portion of the inside of the nozzle NZ with substantially the same (or similar) thickness.

The fourth coating film CF4 may be disposed under the third coating film CF3. The fourth coating film CF4 may contact at least a portion of the third coating film CF3. For example, the fourth coating film CF4 may contact a surface of the third coating film CF3 facing the lower surface LS of the nozzle plate NPT. For example, the fourth coating film CF may not extend to the inside of the nozzle NZ.

The fourth coating film CF4 may have liquid repellency. The fourth coating film CF4 may include a compound having hydrophobic characteristics. For example, the fourth coating film CF4 may have a water contact angle of about 100 degrees to about 200 degrees based on DI water.

The fourth coating film CF4 may include a different material from the first, second, and third coating films CF1, CF2, and CF3. In an embodiment, the fourth coating film CF4 may include a polymer compound including fluorine (F) and silicon (Si) (e.g., perfluoroalkoxy alkane (PFA), and the like).

For example, an average thickness of the fourth coating film CF4 may be in a range of about 25 nm or less. However, embodiments are not limited thereto.

In an embodiment, in case that the ink is present (or disposed) inside the inkjet head IH (e.g., the inside the nozzle part NP), a brightness ratio of a first area of the inkjet head IH (e.g., the nozzle part NP) where each of the nozzles NZ is located in a second area of the inkjet head IH (e.g., the nozzle part NP) excluding the nozzles NZ is about 1 or less. For example, the average thickness of the second coating film CF2 may satisfy the range of about 30 nm or more.

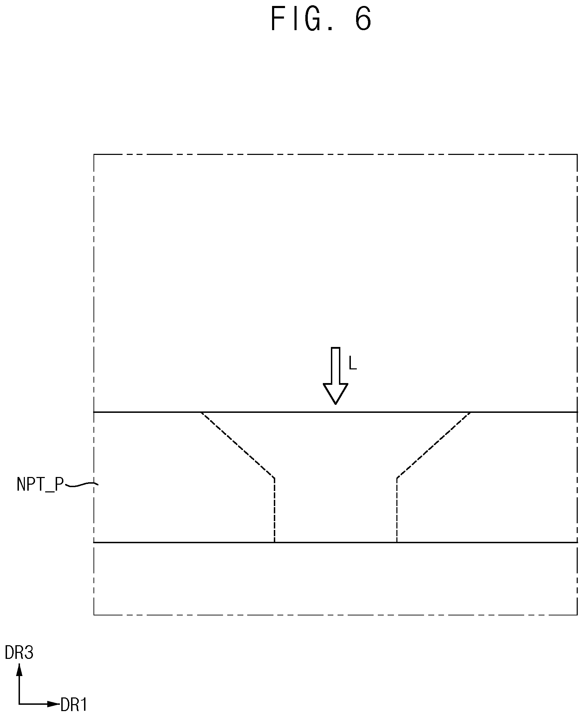

FIGS. 6, 7, 8, 9, 10, 11, and 12 are schematic cross-sectional views for explaining a method of manufacturing the inkjet head of FIG. 5. For example, FIGS. 6, 7, 8, 9, 10, 11, and 12 are schematic cross-sectional views illustrating a method of manufacturing the nozzle part NP included in the inkjet head IH of FIG. 5.

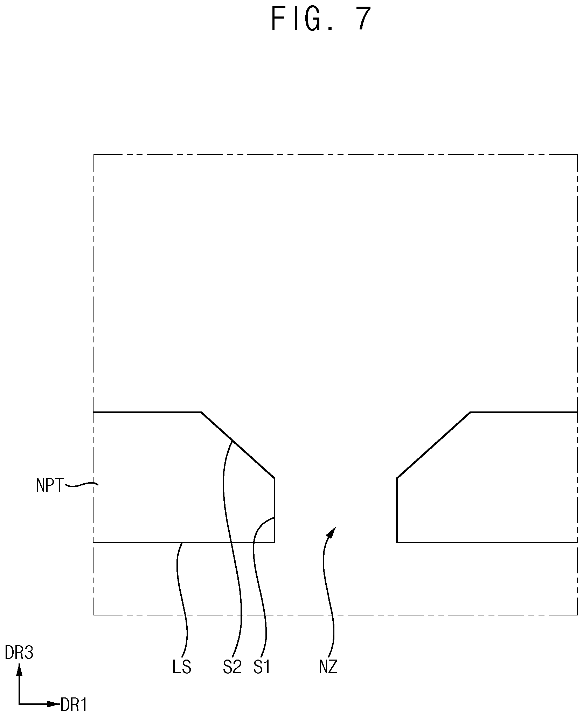

Referring to FIGS. 6 and 7, a preliminary nozzle plate NPT_P including an organic material may be formed. For example, the preliminary nozzle plate NPT_P may include an organic material such as polyimide (PI).

A laser L may be irradiated to the preliminary nozzle plate NPT_P. For example, the nozzle NZ may be formed by processing the preliminary nozzle plate NPT_P with the laser L. Accordingly, the nozzle plate NPT including the plurality of nozzles NZ may be formed. In an embodiment, before forming the first, second, third, and fourth coating films CF1, CF2, CF3, and CF4 of FIG. 5, the nozzle NZ may be formed by processing the preliminary nozzle plate NPT_P with the laser L. Accordingly, a step may not be formed between the nozzle plate NPT and the first coating film CF1.

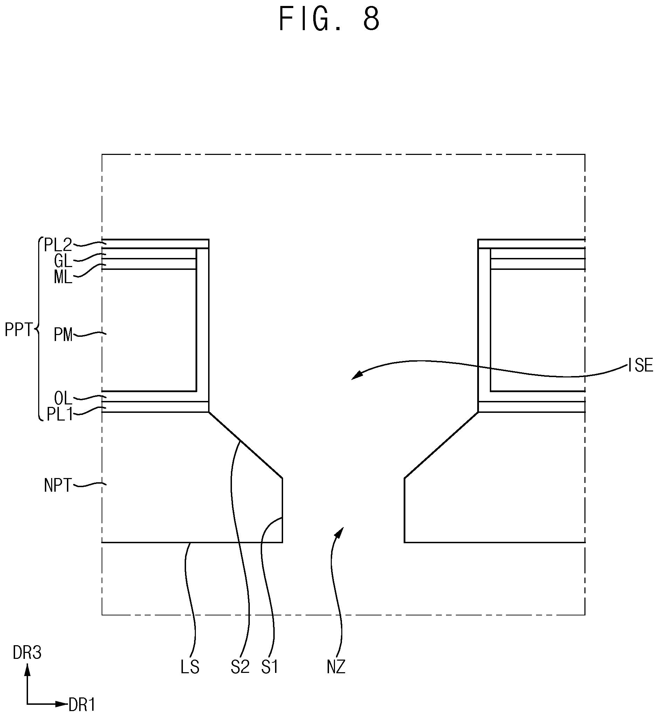

Referring to FIG. 8, the piezoelectric plate PPT may be formed on the nozzle plate NPT. For example, the first polymer layer PL1, the organic layer OL, the piezoelectric member PM, the metal layer ML, the glass layer GL, and the second polymer layer PL2 may be sequentially formed on the nozzle plate NPT. The ink supply passage ISE penetrating the piezoelectric plate PPT and connected to the nozzle NZ may be formed in the piezoelectric plate PPT.

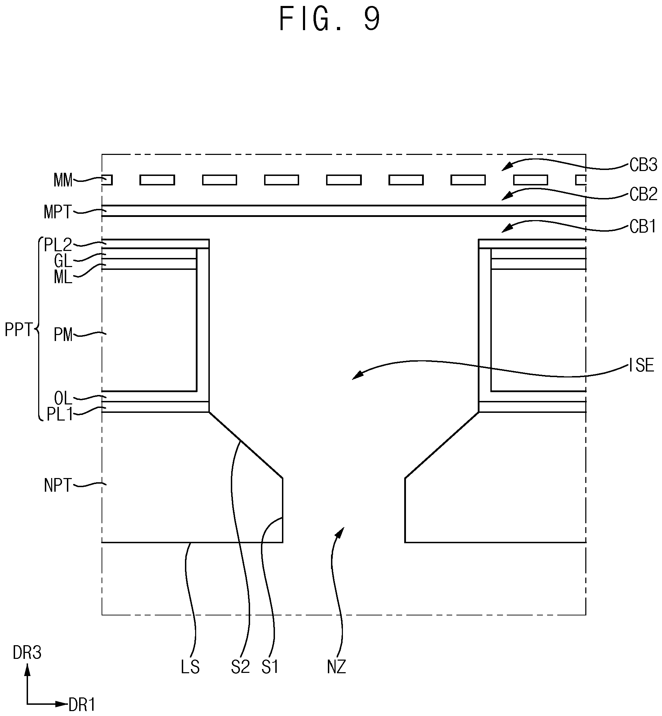

Referring to FIG. 9, the metal plate MPT and the metal mesh MM may be sequentially formed on the piezoelectric plate PPT. For example, the metal plate MPT and metal mesh MM may include stainless steel.

As the metal plate MPT and the metal mesh MM are sequentially formed on the piezoelectric plate PPT, the first ink chamber CB1 may be defined (or formed) between the piezoelectric plate PPT and the metal plate MPT, the second ink chamber CB2 may be defined (or formed) between the metal plate MPT and the metal mesh MM, and the third ink chamber CB3 may be defined (or formed) on the metal mesh MM. The first, second, and third ink chambers CB1, CB2, and CB3 may be connected to each other through a connection passage, and the first ink chamber CB1 may be connected to the ink supply passage ISE.

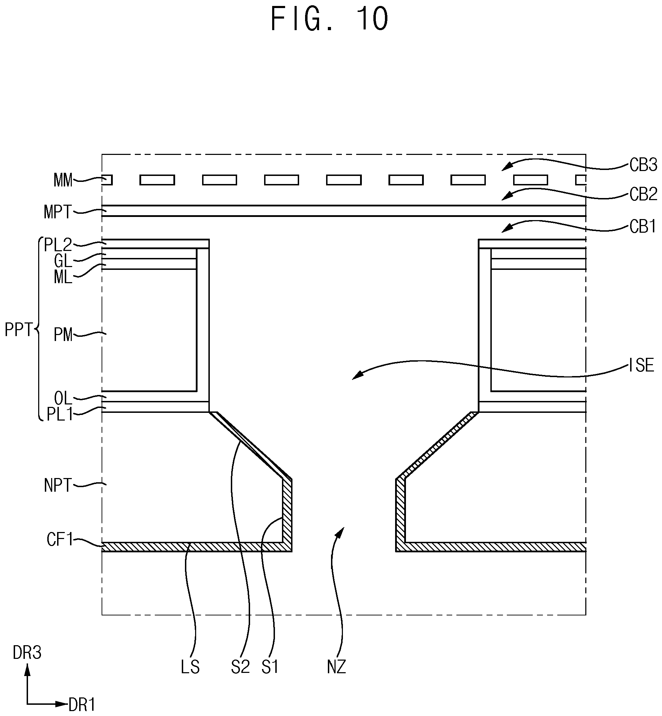

Referring to FIG. 10, the first coating film CF1 may be formed on the lower surface LS of the nozzle plate NPT. The first coating film CF1 may be formed to extend to at least a portion of the inside of the nozzle NZ. In an embodiment, the first coating film CF1 may be formed to cover (e.g., entirely cover) the inner surface of the nozzle plate NPT exposed by the nozzle NZ. In an embodiment, the first coating film CF1 may include an inorganic material and an organic material. For example, the first coating film CF1 may be formed through a chemical vapor deposition (CVD) process, an atomic layer deposition (ALD) process, or a physical vapor deposition (PVD) process.

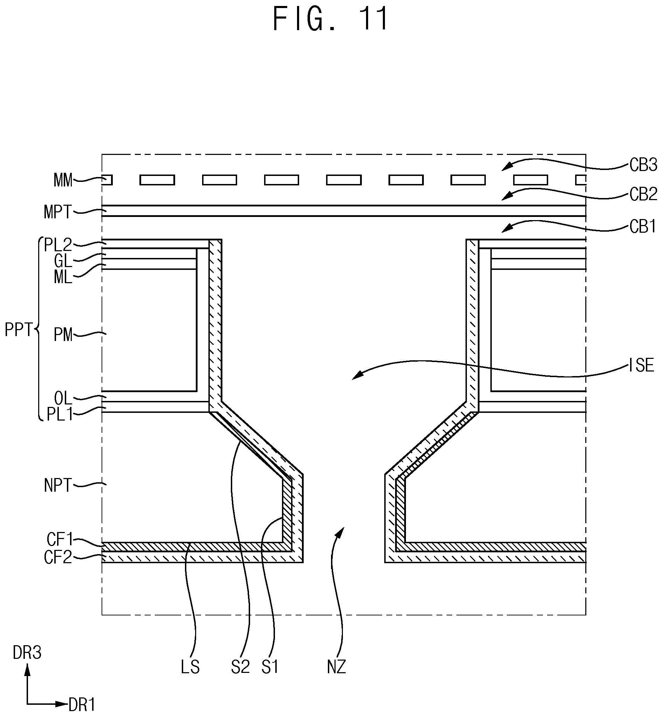

Referring to FIG. 11, the second coating film CF2 may be formed under the first coating film CF1. The second coating film CF2 may be formed to cover the first coating film CF1. In an embodiment, the second coating film CF2 may be formed to cover (e.g., entirely cover) the side surface of the piezoelectric plate PPT. In an embodiment, the second coating film CF2 may include a metal oxide and/or an organic-inorganic composite material including a metal oxide. For example, the second coating film CF2 may be formed through a chemical vapor deposition process, an atomic layer deposition process, or a physical vapor deposition process.

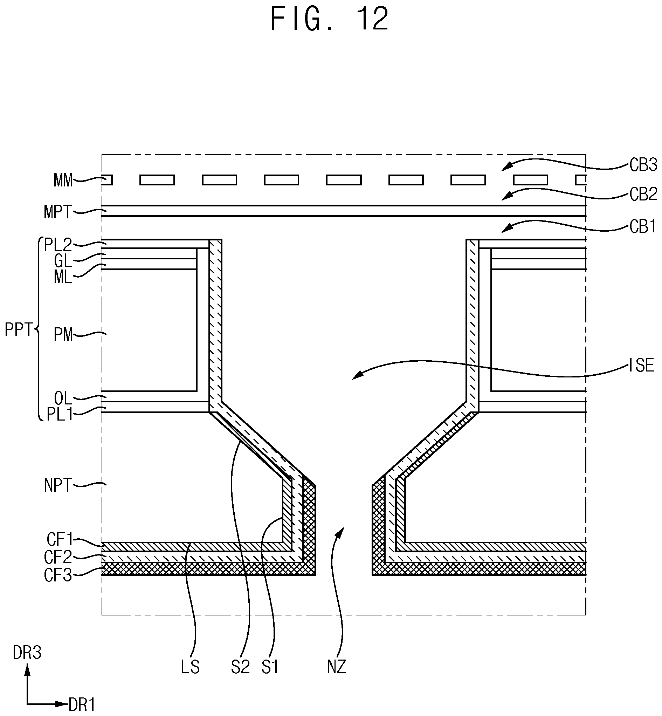

Referring to FIG. 12, the third coating film CF3 may be formed under the second coating film CF2. In an embodiment, the third coating film CF3 may be formed to extend to at least a portion of the inside of the nozzle NZ. In an embodiment, the third coating film CF3 may include an inorganic material. For example, the third coating film CF3 may be formed through a chemical vapor deposition process, an atomic layer deposition process, or a physical vapor deposition process.

Referring again to FIG. 5, the fourth coating film CF4 may be formed under the third coating film CF3. The fourth coating film CF4 may not be formed to extend to the inside of the nozzle NZ. The fourth coating film CF4 may have liquid repellency. In an embodiment, the fourth coating film CF4 may include a polymer compound having hydrophobic characteristics and including fluorine (F) and silicon (Si). For example, the fourth coating film CF4 may be formed through a physical vapor deposition process.

Referring again to FIG. 3, the inlet II, and the outlet OUL connected to the nozzle part NP are formed, and the driving part DP may be inserted into the nozzle part NP. Accordingly, the inkjet head IH of FIG. 3 may be manufactured.

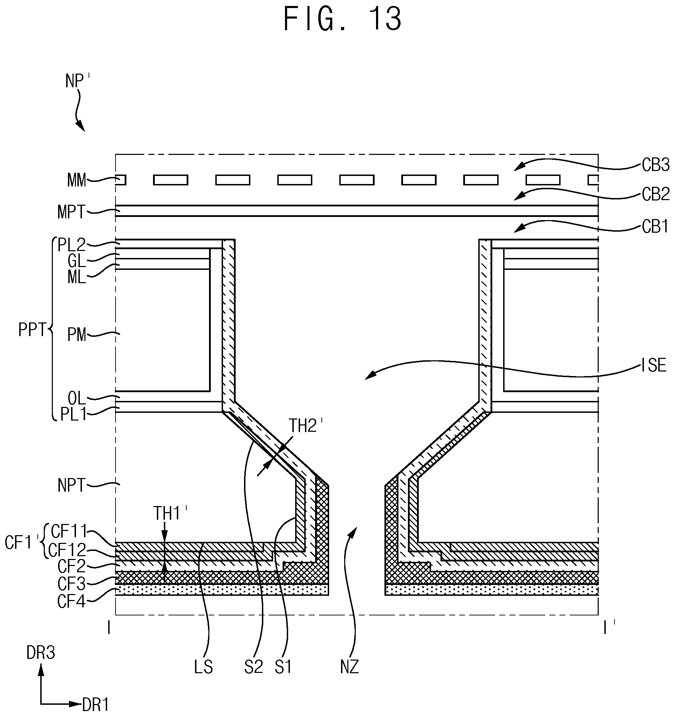

FIG. 13 is a schematic cross-sectional view illustrating another example of a cross-section taken along line I-I' of FIG. 3.

A nozzle part NP' of the inkjet head described with reference to FIG. 13 may be substantially the same as or similar to the nozzle part NP of the inkjet head IH described with reference to FIG. 5 except for a first coating film CF1'. Hereinafter, overlapping descriptions are omitted or simplified for descriptive convenience.

Referring to FIG. 13, the nozzle part NP' of the inkjet head may include a nozzle plate NPT, first, second, third, and fourth coating films CF1', CF2, CF3, and CF4, a piezoelectric plate PPT, a metal plate MPT, and metal mesh MM. For example, the piezoelectric plate PPT may include a first polymer layer PL1, an organic layer OL, a piezoelectric member PM, a metal layer ML, a glass layer GL, and a second polymer layer PL2.

The first-first coating film CF11 may be disposed on the lower surface LS of the nozzle plate NPT. A step may be defined (or formed) between the nozzle plate NPT and the first-first coating film CF11. For example, the first-first coating film CF11 may expose a portion of the lower surface LS of the nozzle plate NPT adjacent to the nozzle NZ. In an embodiment, the first-first coating film CF11 may include an inorganic material and an organic material. For example, the first-first coating film CF11 may include silicon oxycarbide (SiOC). However, embodiments are not limited thereto.

The first-second coating film CF12 may be disposed under the first-first coating film CF11. The first-second coating film CF12 may cover the first-first coating film CF11 and may also be disposed on the inner surface of the nozzle plate NPT. In an embodiment, the first-second coating film CF12 may extend from the lower surface LS of the nozzle plate NPT to cover the inner surface of the nozzle plate NPT. For example, the first-second coating film CF12 may cover (e.g., entirely cover) the inner surface of the nozzle plate NPT. For example, the first-second coating film CF12 may contact the lower surface of the first-first coating film CF11 and the inner surface of the nozzle plate NPT. As the first-second coating film CF12 covers the inner surface of the nozzle plate NPT, the step between the first-first coating film CF11 and the nozzle plate NPT may be compensated. Accordingly, the occurrence of scratches, tears, and the like in the first-first coating film CF11 and the first-second coating film CF12 may be reduced.

In an embodiment, the first-second coating film CF12 may include an inorganic material and an organic material. For example, the first-second coating film CF12 may include silicon oxycarbide (SiOC). However, embodiments are not limited thereto.

For example, the first-first coating film CF11 and the first-second coating film CF12 may include the same material. However, embodiments are not limited thereto.

The first-first coating film CF11 and the first-second coating film CF12 may be combined to be defined (or formed) as the first coating film CF1'. As a result, a portion of the first coating film CF1' facing the lower surface LS of the nozzle plate NPT may be constituted of (or formed as) a double film, and the first coating film CF1' facing the inner surface of the nozzle plate NPT may be constituted of (or formed as) a single film.

For example, the average thickness of the first coating film CF1' may be in a range of about 5 nm to about 25 nm. However, embodiments are not limited thereto. For example, a first thickness TH1' of the portion of the first coating film CF1' contacting the lower surface LS of the nozzle plate NPT may be different from a second thickness TH2' of the portion of the first coating film CF1' contacting the inner surface of the nozzle plate NPT. In an embodiment, the first thickness TH1' of the portion of the first coating film CF1' contacting the lower surface LS of the nozzle plate NPT may be thicker than the second thickness TH2' of the portion of the first coating film CF1' contacting the inner surface of the nozzle plate NPT.

The second coating film CF2 may be disposed under the first coating film CF1'. The second coating film CF2 may extend from under the first coating film CF1' to cover at least a portion of the side surface of the piezoelectric plate PPT. In an embodiment, the second coating film CF2 may cover (e.g., entirely cover) the side surface of the piezoelectric plate PPT. For example, the second coating film CF2 may contact (e.g., entirely contact) the first coating film CF1' and may contact the side surface of the piezoelectric plate PPT. The second coating film CF2 may include a different material from the first coating film CF1'. In an embodiment, the second coating film CF2 may include a metal oxide and/or an organic-inorganic composite material including a metal oxide.

For example, the average thickness of the second coating film CF2 may be in a range of about 5 nm to about 1000 nm.

The third coating film CF3 may be disposed under the second coating film CF2. The third coating film CF3 may cover at least a portion of the second coating film CF2.

The third coating film CF3 may extend from under the second coating film CF2 to at least a portion of the inside of the nozzle NZ. In an embodiment, the third coating film CF3 may extend from under the second coating film CF2 to the inside of the nozzle NZ to face the first side surface S1 of the inner surfaces of the nozzle plate NPT. For example, the third coating film CF3 may contact a portion of the second coating film CF2. However, embodiments are not limited thereto. In another embodiment, the third coating film CF3 may extend to cover (e.g., entirely cover) the second coating film CF2. For example, the third coating film CF3 may contact (e.g., entirely contact) the second coating film CF2. The third coating film CF3 may include a different material from the first and second coating films CF1 and CF2. In an embodiment, the third coating film CF3 may include an inorganic material.

For example, the average thickness of the third coating film CF3 may be in a range of about 5 nm to about 1000 nm. However, embodiments are not limited thereto.

The fourth coating film CF4 may be disposed under the third coating film CF3. The fourth coating film CF4 may contact at least a portion of the third coating film CF3. For example, the fourth coating film CF4 may contact the side surface of the third coating film CF3 facing the lower surface LS of the nozzle plate NPT. For example, the fourth coating film CF may not extend to the inside of the nozzle NZ. The fourth coating film CF4 may have liquid repellency. In an embodiment, the fourth coating film CF4 may include a polymer compound having hydrophobic characteristics and including fluorine (F) and silicon (Si).

For example, the average thickness of the fourth coating film CF4 may be in a range of about 25 nm or less. However, embodiments are not limited thereto.

In an embodiment, in case that the ink is present (or disposed) inside the inkjet head (e.g., the inside the nozzle part NP'), a brightness ratio of a first area of the inkjet head (e.g., the nozzle part NP') where each of the nozzles NZ is located in a second area of the inkjet head (e.g., the nozzle part NP') excluding the nozzles NZ is about 1 or less. For example, the average thickness of the second coating film CF2 may satisfy the range of about 30 nm or more.

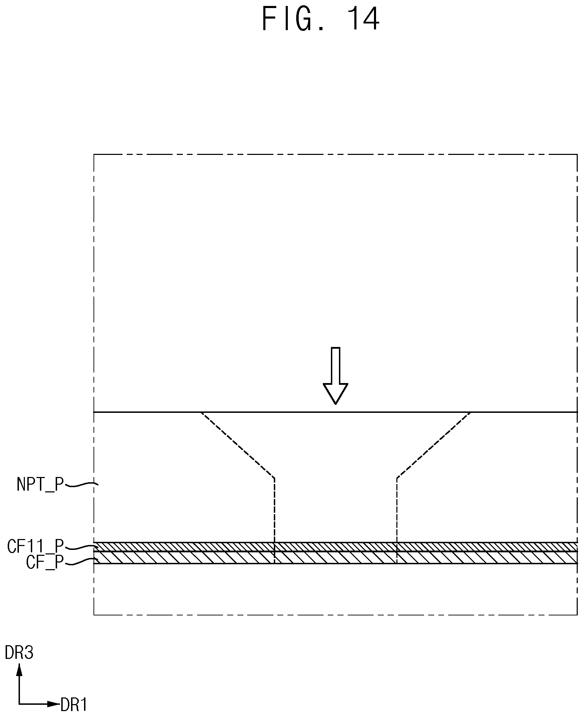

FIGS. 14, 15, 16, 17, 18, 19, 20, and 21 are schematic cross-sectional views for explaining a method of manufacturing the inkjet head of FIG. 13. For example, FIGS. 14, 15, 16, 17, 18, 19, 20, and 21 are schematic cross-sectional views illustrating a method of manufacturing the nozzle part NP' included in the inkjet head of FIG. 13.

Hereinafter, descriptions that overlap with the content of the method of manufacturing the inkjet head IH described with reference to FIGS. 6, 7, 8, 9, 10, 11, and 12 will be omitted or simplified for descriptive convenience.

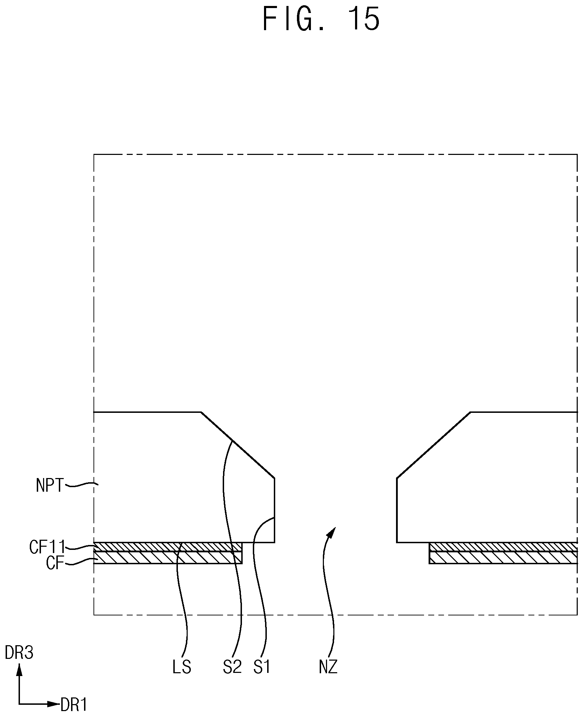

Referring to FIGS. 14 and 15, a preliminary nozzle plate NPT_P including an organic material may be formed. For example, the preliminary nozzle plate NPT_P may include an organic material such as polyimide (PI).

A preliminary first-first coating film CF11_P may be formed (e.g., entirely formed) on a lower surface of the preliminary nozzle plate NPT_P. In an embodiment, the preliminary first-first coating film CF11_P may include an inorganic material and an organic material. For example, the preliminary first-first coating film CF11_P may be formed through a chemical vapor deposition process, an atomic layer deposition process, or a physical vapor deposition process.

A preliminary sacrificial coating film CF_Pmay be formed (e.g., entirely formed) on a lower surface of the preliminary first-first coating layer CF11_P. The preliminary sacrificial coating film CF_P may have liquid repellency. The preliminary sacrificial coating film CF_P may include a different material from the preliminary first-first coating layer CF11_P. In an embodiment, the preliminary sacrificial coating film CF_P may include a polymer compound having hydrophobic characteristics and including fluorine (F) and silicon (Si). For example, the preliminary sacrificial coating film CF_P may be formed through a physical vapor deposition process.

A laser L may be irradiated to the preliminary nozzle plate NPT_P, the preliminary first-first coating film CF11_P, and the preliminary sacrificial coating film CF_P. For example, the nozzle plate NPT in which the plurality of nozzles NZ are defined (or formed), the first-first coating film CF11, and the sacrificial coating film CF may be formed by processing the preliminary nozzle plate NPT_P, the preliminary first-first coating film CF11_P, and the preliminary sacrificial coating film CF_P with a laser L. At this time, a step may be formed between the nozzle plate NPT and the first-first coating film CF11, and a step may be formed between the nozzle plate NPT and the sacrificial coating film CF. For example, the first-first coating film CF11 and the sacrificial coating film CF may expose a portion of the lower surface LS of the nozzle plate NPT adjacent to the nozzle NZ.

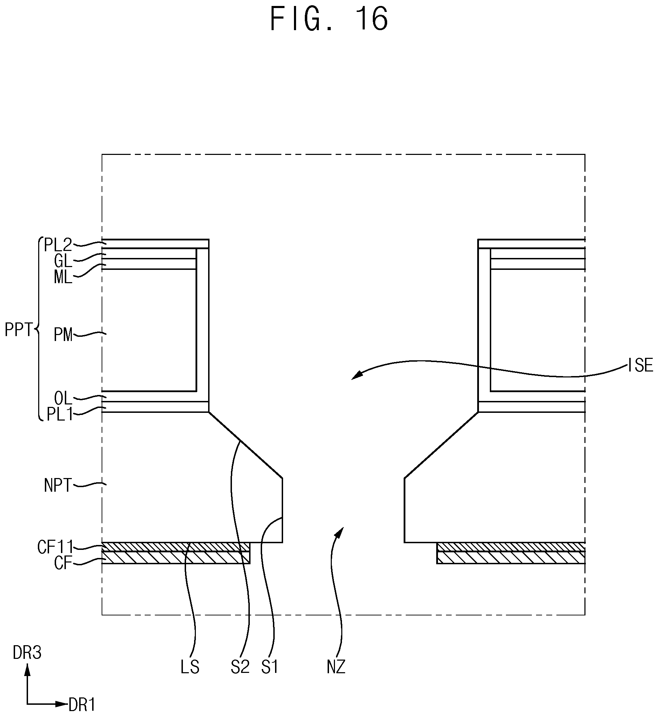

Referring to FIG. 16, the piezoelectric plate PPT may be formed on the nozzle plate NPT. For example, the first polymer layer PL1, the organic layer OL, the piezoelectric member PM, the metal layer ML, the glass layer GL, and the second polymer layer PL2 may be sequentially formed on the nozzle plate NPT. The ink supply path ISE penetrating the piezoelectric plate PPT and connected to the nozzle NZ may be formed in the piezoelectric plate PPT.

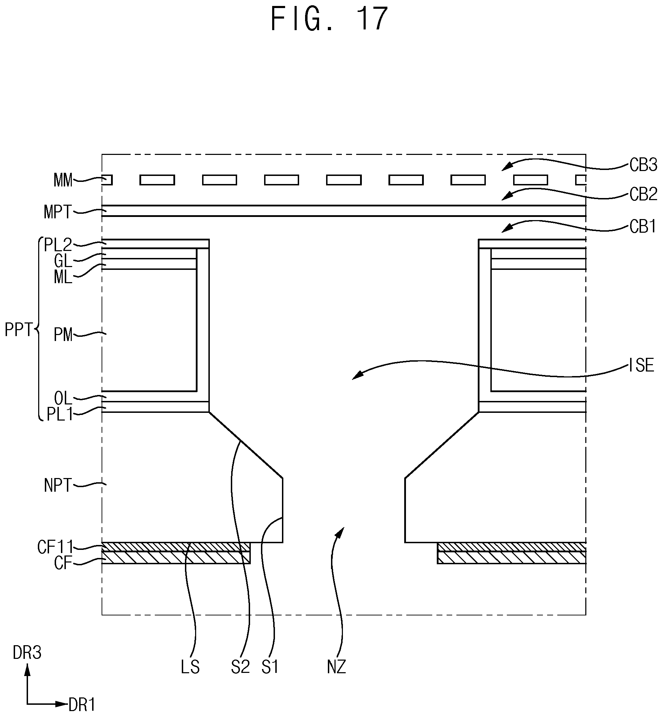

Referring to FIG. 17, the metal plate MPT and the metal mesh MM may be sequentially formed on the piezoelectric plate PPT.

As the metal plate MPT and the metal mesh MM are sequentially formed on the piezoelectric plate PPT, the first ink chamber CB1 may be defined (or formed) between the piezoelectric plate PPT and the metal plate MPT, the second ink chamber CB2 may be defined (or formed) between the metal plate MPT and the metal mesh MM, and the third ink chamber CB3 may be defined (or formed) on the metal mesh MM. The first, second, and third ink chambers CB1, CB2, and CB3 may be connected to each other through a connection passage, and the first ink chamber CB1 may be connected to the ink supply passage ISE.

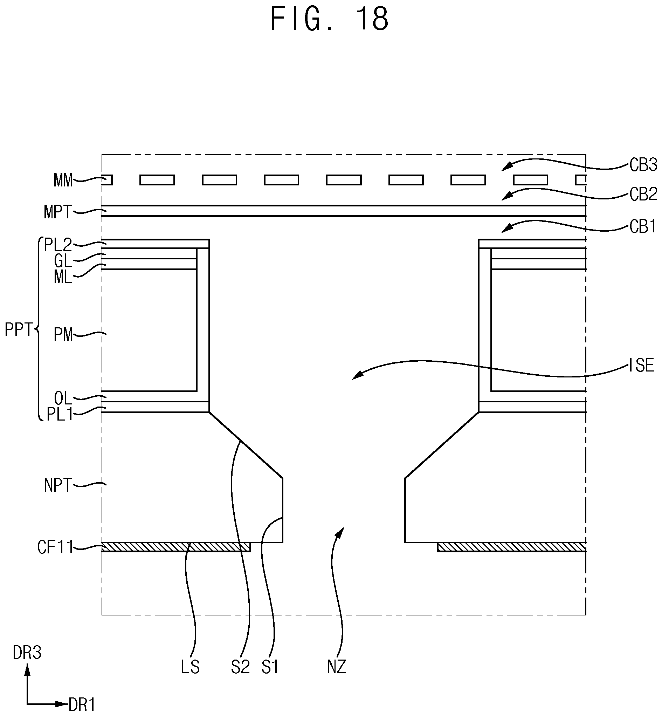

Referring to FIG. 18, in an embodiment, the sacrificial coating film CF may be removed. For example, the sacrificial coating film CF may be removed through an etching process.

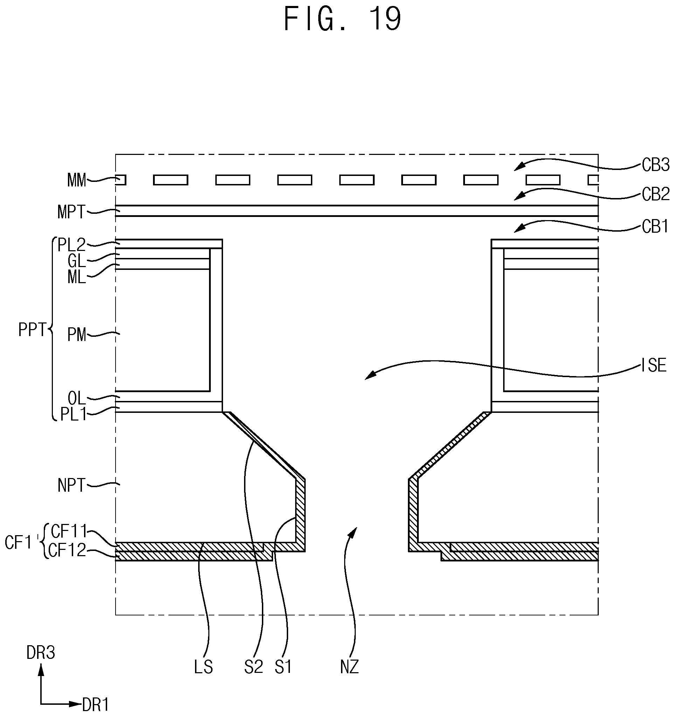

Referring to FIG. 19, the first-second coating film CF12 may be formed under the first-first coating film CF11. The first-second coating film CF12 may be formed to cover the first-first coating film CF11. In an embodiment, the first-second coating film CF12 may be formed to cover (e.g., entirely cover) the inner surface (e.g., the first side surface S1 and the second side surface S2) of the nozzle plate NPT exposed by the nozzle NZ. In an embodiment, the first-second coating film CF12 may include an inorganic material and an organic material. For example, the first-second coating film CF12 may be formed through a chemical vapor deposition process, an atomic layer deposition process, or a physical vapor deposition process.

The first-first coating film CF11 and the first-second coating film CF12 may be combined to form the first coating film CF1'.

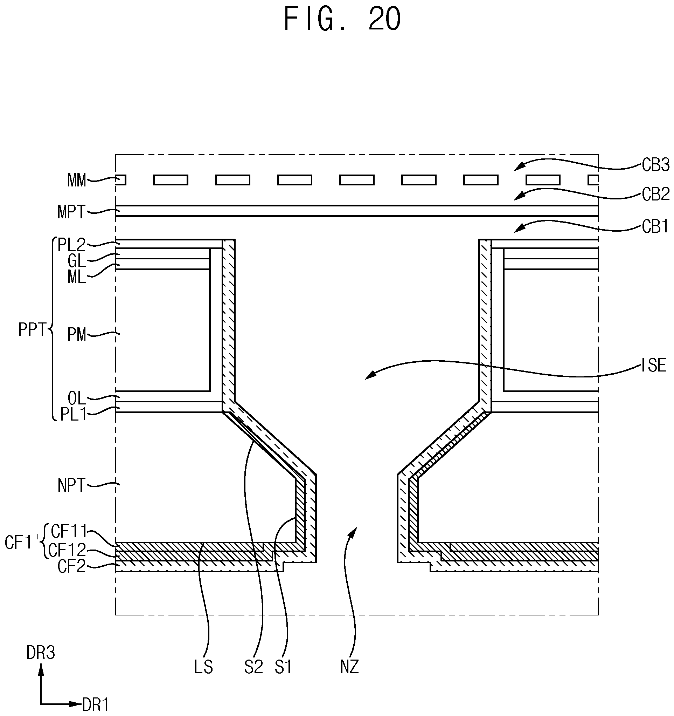

Referring to FIG. 20, the second coating film CF2 may be formed under the first coating film CF1' to cover the first coating film CF1'. In an embodiment, the second coating film CF2 may be formed to cover (e.g., entirely cover) the side surface of the piezoelectric plate PPT. In an embodiment, the second coating film CF2 may include a metal oxide and/or an organic-inorganic composite material including a metal oxide.

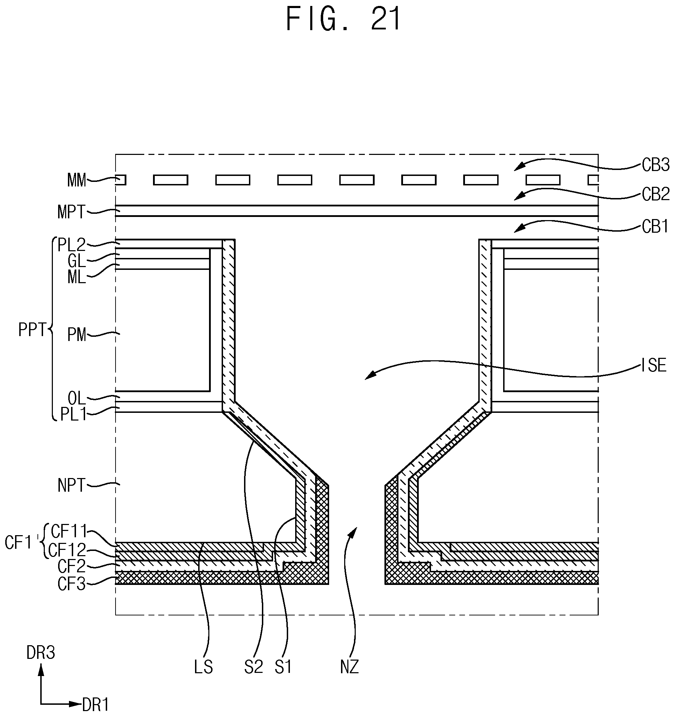

Referring to FIG. 21, the third coating film CF3 may be formed under the second coating film CF2. In an embodiment, the third coating film CF3 may be formed to extend to at least a portion of the inside of the nozzle NZ. In an embodiment, the third coating film CF3 may include an inorganic material.

Referring again to FIG. 13, the fourth coating film CF4 may be formed under the third coating film CF3. The fourth coating film CF4 may not be formed to extend to the inside of the nozzle NZ. The fourth coating film CF4 may have liquid repellency. In an embodiment, the fourth coating film CF4 may include a polymer compound having hydrophobic characteristics and including fluorine (F) and silicon (Si).

An inlet and an outlet connected to the nozzle part NP' may be formed, and a driving part may be inserted into the nozzle part NP'. The inlet, the outlet, and the driving part may correspond to the inlet IL, the outlet OUL, and the driving part DP of FIG. 3, respectively. Accordingly, the inkjet head may be manufactured.

In an inkjet head according to comparative example, a step was formed between a nozzle plate including an organic material and a first coating film including an organic material and an inorganic material. Accordingly, frictional force may be concentrated on the step due to repeated discharge of ink and the ink blotting process. For example, the first coating film may be damaged and the ink discharge characteristics of the inkjet head may deteriorate.

Referring again to FIGS. 1, 2, 3, 4, and 5 and 13, in the inkjet head IH according to embodiments, the nozzle part NP and NP' of the inkjet head IH may include the nozzle plate NPT including an organic material, the first coating film CF1 and CF1' disposed on the lower surface LS of the nozzle plate NPT and the inner surface (e.g., the first side surface S1 and the second side surface S2) of the nozzle plate NPT exposed by each of the nozzles NZ, the second coating film CF2 covering the first coating film CF1, the third coating film CF3 disposed under the second coating film CF2 and covering at least a portion of the second coating film CF2, and the fourth coating film CF4 disposed under the third coating film CF3. The first coating film CF1 and CF1' may include an inorganic material and an organic material, the second coating film CF2 may include a metal oxide, the third coating film CF3 may include an inorganic material, and the fourth coating film CF4 may have liquid repellency.

Accordingly, the occurrence of scratches, tears, and the like in the first coating film CF1 and CF1' may be reduced. For example, deterioration in the ink discharge characteristics of the inkjet head IH may be reduced, and the wear resistance of the inkjet head IH may be improved.

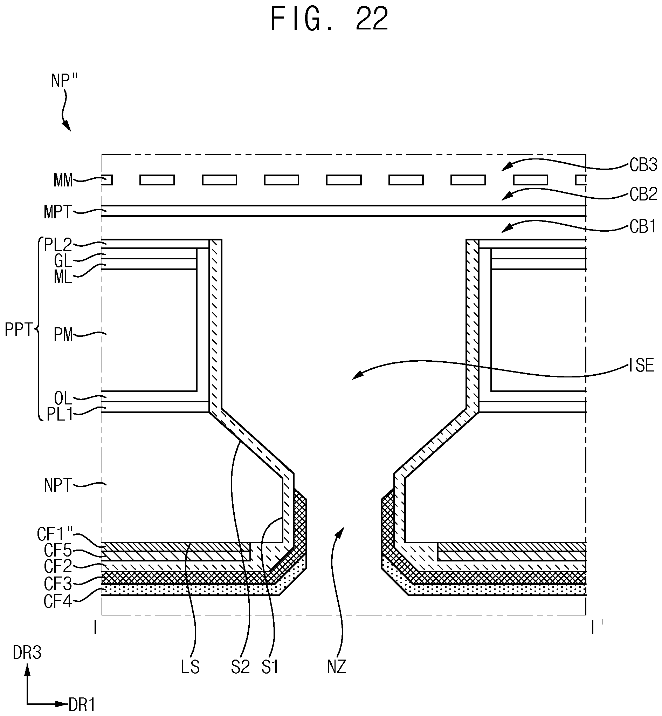

FIG. 22 is a schematic cross-sectional view illustrating still another example of a cross-section taken along line I-I' of FIG. 3.

A nozzle part NP" of the inkjet head described with reference to FIG. 22 may be substantially the same or similar to the nozzle part NP of the inkjet head IH described with reference to FIG. 5 except for a first coating film CF1" and a fifth coating film CF5. Hereinafter, overlapping descriptions are omitted or simplified for descriptive convenience.

Referring to FIG. 22, the nozzle part NP" of the inkjet head may include a nozzle plate NPT, first, second, third, fourth, and fifth coating films CF1", CF2, CF3, CF4, and CF5, a piezoelectric plate PPT, a metal plate MPT, and a metal mesh MM. For example, the piezoelectric plate PPT may include a first polymer layer PL1, an organic layer OL, a piezoelectric member PM, a metal layer ML, a glass layer GL, and a second polymer layer PL2.

The first coating film CF1" may be disposed on the lower surface LS of the nozzle plate NPT. A step may be defined (or formed) between the nozzle plate NPT and the first coating film CF1". For example, the first coating film CF1" may expose a portion of the lower surface LS of the nozzle plate NPT adjacent to the nozzle NZ. In an embodiment, the first coating film CF1" may include an inorganic material and an organic material. For example, the first coating film CF1" may include silicon oxycarbide (SiOC). However, embodiments are not limited thereto.

The fifth coating film CF5 may be disposed on a lower surface of the first coating film CF1". For example, the fifth coating film CF5 may contact the lower surface of the first coating film CF1". A step may be defined (or formed) between the fifth coating film CF5 and the nozzle plate NPT. For example, the fifth coating film CF5 may expose a portion of the lower surface LS of the nozzle plate NPT adjacent to the nozzle NZ. The fifth coating film CF5 may have liquid repellency. In an embodiment, the fifth coating film CF5 may include a polymer compound having hydrophobic characteristics and including fluorine (F) and silicon (Si).

The second coating film CF2 covering the first coating film CF1 and the fifth coating film CF5 may be disposed under the fifth coating film CF5. The second coating film CF2 may extend from under the fifth coating film CF5 to cover at least a portion of the side surface of the piezoelectric plate PPT. In an embodiment, the second coating film CF2 may cover (e.g., entirely cover) the side surface of the piezoelectric plate PPT. For example, the second coating film CF2 may contact a lower surface of the fifth coating film CF5 and the side surface of the piezoelectric plate PPT. As the second coating film CF2 covers the first coating film CF1" and the fifth coating film CF5, the step between the first coating film CF1" and the nozzle plate NPT and the step between the fifth coating film CF5 and the nozzle plate NPT may be compensated. Accordingly, the occurrence of scratches, tears, and the like in the first coating film CF1" and the second coating film CF2 may be reduced.

In an embodiment, the second coating film CF2 may include a metal oxide and/or an organic-inorganic composite material including a metal oxide.

The third coating film CF3 may be disposed under the second coating film CF2. The third coating film CF3 may cover at least a portion of the second coating film CF2. For example, the third coating film CF3 may extend from under the second coating film CF2 to at least a portion of the inside of the nozzle NZ. In an embodiment, the third coating film CF3 may include an inorganic material.

The fourth coating film CF4 may be disposed under the third coating film CF3. The fourth coating film CF4 may contact at least a portion of the third coating film CF3. For example, the fourth coating film CF4 may contact the side surface of the third coating film CF3 facing the lower surface LS of the nozzle plate NPT. For example, the fourth coating film CF may not extend to the inside of the nozzle NZ. The fourth coating film CF4 may have liquid repellency. In an embodiment, the fourth coating film CF4 may include a polymer compound having hydrophobic characteristic and including fluorine (F) and silicon (Si).

In an embodiment, in case that the ink is present (or disposed) inside the inkjet head (e.g., the inside the nozzle part NP"), a brightness ratio of a first area of the inkjet head (e.g., the nozzle part NP") where each of the nozzles NZ is located in a second area of the inkjet head (e.g., the nozzle part NP") excluding the nozzles NZ is about 1 or less. For example, the average thickness of the second coating film CF2 may be in a range of about 30 nm or more.

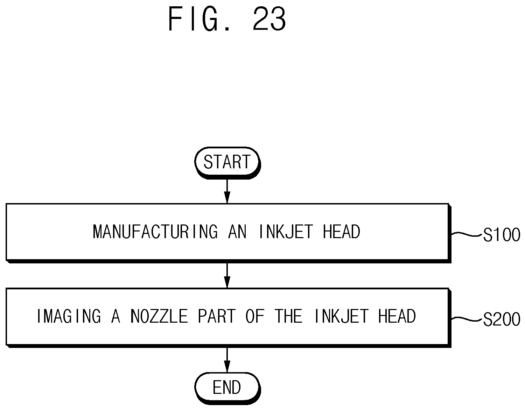

FIG. 23 is a flowchart illustrating a method of inspection the inkjet head according to embodiments.

Referring to FIG. 23, a method of inspecting an inkjet head may include manufacturing the inkjet head S100 and imaging a nozzle part of the inkjet head S200.

For example, the inkjet head may be manufactured S100. The inkjet head may include the nozzle part, an inlet connected to the nozzle part, an outlet connected to the nozzle part, and a driving part inserted into and fixed to the nozzle part. For example, the nozzle part may correspond to the nozzle part NP of FIG. 5, the nozzle part NP' of FIG. 13, or the nozzle part NP" of FIG. 22, the inlet may correspond to the inlet IL of FIG. 3, the outlet may correspond to the outlet OUL of FIG. 3, and the driving part may correspond to the driving part DP of FIG. 3.

In an embodiment, in case that the ink (e.g., the ink IK of FIG. 1) is present (or disposed) inside the inkjet head (e.g., inside the nozzle part), the nozzle part of the inkjet head may be imaged as a 2D image S200. For example, the nozzle part of the inkjet head may be imaged using a microscope in reflection mode or transmission mode. However, embodiments are not limited thereto.

Through the 2D image, an amount of gray level change between a first area of the inkjet head where each of nozzles (e.g., the nozzles of FIG. 4) is located and a second area of the inkjet head excluding the nozzles may be measured. For example, in case that the ink is present (or disposed) inside the inkjet head (e.g., inside the nozzle part), the brightness ratio of the first area to the second area may be about 1 or less.

Through method of inspecting the inkjet head, it may be confirmed whether the second coating film (e.g., the second coating film CF2 of FIG. 5, FIG. 13, or FIG. 22) included in the nozzle part NP, NP', and NP" of the inkjet head is deposited. For example, the average thickness of the second coating film CF2 may be in a range of about 30 nm or more.

Embodiments may be applied to a process for manufacturing various display devices. For example, Embodiments may be applicable to the process for manufacturing various display devices such as display devices for vehicles, ships and aircraft, portable communication devices, display devices for exhibition or information transmission, medical display devices, and the like.

In concluding the detailed description, those skilled in the art will appreciate that many variations and modifications may be made to the embodiments without substantially departing from the scope of the appended claims. Therefore, the disclosed embodiments are used in a generic and descriptive sense only and not for purposes of limitation.

Embodiments are set out in the following clauses:
1. A method of manufacturing an inkjet head, the method comprising:
   forming a preliminary nozzle plate including an organic material;
   forming a nozzle plate including a plurality of nozzles formed by processing the preliminary nozzle plate using a laser;
   forming a piezoelectric plate on the nozzle plate;
   forming a first coating film on a lower surface of the nozzle plate;
   forming a second coating film covering the first coating film and including a material different from the first coating film;
   forming a third coating film including a material different from the first and second coating films and disposed under the second coating film; and
   forming a fourth coating film including a material different from the first, second, and third coating films and disposed under the third coating film.
2. The method of clause 1, wherein in the forming of the first coating film, the first coating film is formed to entirely cover an inner surface of the nozzle plate exposed by each of the nozzles.
3. The method of any preceding clause, wherein in the forming of the second coating film, the second coating film is formed to entirely cover a side surface of the piezoelectric plate.
4. The method of any preceding clause, wherein
   the first coating film includes an organic material and an inorganic material,
   the second coating film includes at least one of a metal oxide and an organic-inorganic composite material including the metal oxide,
   the third coating film includes an inorganic material, and
   the fourth coating film includes a polymer compound having hydrophobic characteristics and including fluorine (F) and silicon (Si).
5. The method of any preceding clause, wherein the preliminary nozzle plate includes polyimide (PI).
6. The method of any preceding clause, wherein the forming of the piezoelectric plate includes:
   forming a first polymer layer on the nozzle plate;
   forming an organic layer on the first polymer layer;
   forming a piezoelectric member on the organic layer;
   forming a metal layer on the piezoelectric member;
   forming a glass layer on the metal layer; and
   forming a second polymer layer on the glass layer and the organic layer.
7. A method of manufacturing an inkjet head, the method comprising:
   forming a preliminary nozzle plate including an organic material;
   forming a preliminary first-first coating film on a lower surface of the preliminary nozzle plate;
   forming a preliminary sacrificial coating film including a material different from the preliminary first-first coating film on a lower surface of the preliminary first-first coating film;
   forming a nozzle plate including a plurality of nozzles, a first-first coating film forming a step with the nozzle plate, and a sacrificial coating film forming a step with the nozzle plate by processing the preliminary nozzle plate, the preliminary first-first coating film, and the preliminary sacrificial coating film using a laser;
   forming a piezoelectric plate on the nozzle plate;
   removing the sacrificial coating film;
   forming a first-second coating film covering the first-first coating film on a lower surface of the first-first coating film;
   forming a second coating film covering the first-second coating film and including a material different from the first-first and first-second coating films;
   forming a third coating film including a material different from the first-second and second coating films under the second coating film; and
   forming a fourth coating film including a material different from the first-second, second, and third coating films under the third coating film.
8. The method of clause 7, wherein in the forming of the first-second coating film, the first-second coating film is formed to entirely cover an inner surface of the nozzle plate exposed by each of the nozzles.
9. The method of clause 7 or clause 8, wherein in the forming of the second coating film, the second coating film is formed to entirely cover a side surface of the piezoelectric plate.
10. The method of any of clauses 7 to 9, wherein
   the first-first coating film and the first-second coating film includes an organic material and an inorganic material,
   the second coating film includes at least one of a metal oxide and an organic-inorganic composite material including the metal oxide,
   the third coating film includes an inorganic material, and
   the fourth coating film includes a polymer compound having hydrophobic characteristics and including fluorine (F) and silicon (Si).
11. The method of any of clauses 7 to 10, wherein the preliminary nozzle plate includes polyimide (PI).
12. The method of any of clauses 7 to 11, wherein the forming of the piezoelectric plate includes:
   forming a first polymer layer on the nozzle plate;
   forming an organic layer on the first polymer layer;
   forming a piezoelectric member on the organic layer;
   forming a metal layer on the piezoelectric member;
   forming a glass layer on the metal layer; and
   forming a second polymer layer on the glass layer and the organic layer.
13. An inkjet head comprising:
   a nozzle plate including an organic material and including a plurality of nozzles that discharge an ink to an outside;
   a piezoelectric plate disposed on the nozzle plate;
   a first coating film disposed on a lower surface of the nozzle plate and an inner surface of the nozzle plate exposed by each of the nozzles;
   a second coating film covering the first coating film and including a material different from the first coating film;
   a third coating film disposed under the second coating film, covering at least a portion of the second coating film, and including a material different from the first and second coating films; and
   a fourth coating film disposed under the third coating film and including a material different from the first, second, and third coating films.
14. The inkjet head of clause 13, wherein the first coating film entirely covers the inner surface of the nozzle plate.
15. The inkjet head of clause 13 or clause 14, wherein a first thickness of a portion of the first coating film contacting the lower surface of the nozzle plate is thicker than a second thickness of a portion of the first coating film contacting the inner surface of the nozzle plate.
16. The inkjet head of any of clauses 13 to 15, wherein the second coating film extends from under the first coating film to entirely cover a side surface of the piezoelectric plate.
17. The inkjet head of any of clauses 13 to 16, wherein the third coating film extends from under the second coating film to at least a portion of an inside of the nozzles.
18. The inkjet head of any of clauses 13 to 17, wherein
   the inner surface of the nozzle plate includes a first side surface perpendicular to the lower surface of the nozzle plate and a second side surface inclined in a direction away from each of the nozzles, and
   the third coating film extends from under the second coating film to an inside of the nozzles to face the first side surface of an inner surface of the nozzle plate.
19. The inkjet head of any of clauses 13 to 18, wherein the first coating films includes:
   a first-first coating film disposed on the lower surface of the nozzle plate and forming a step together with the nozzles plate; and
   a first-second coating film disposed on a lower surface of the first-first coating film and the inner surface of the nozzle plate to cover the first-first coating film.
20. The inkjet head of clause 19, wherein a first thickness of a portion of the first coating film contacting the lower surface of the nozzle plate is thicker than a second thickness of a portion of the first coating film contacting the inner surface of the nozzle plate.
21. The inkjet head of any of clauses 13 to 20, wherein
   an average thickness of the first coating film is in a range of about 5 nm to about 25 nm,
   an average thickness of the second coating film is in a range of about 5 nm to about 1000 nm, and
   an average thickness of the third coating film is in a range of about 5 nm to about 1000 nm.
22. The inkjet head of any of clauses 13 to 21, wherein an average thickness of the fourth coating film is in a range of from about 20 nm or less.
23. The inkjet head of any of clauses 13 to 22, wherein
   the first coating film includes an organic material and an inorganic material,
   the second coating film includes at least one of a metal oxide and an organic-inorganic composite material including the metal oxide,
   the third coating film includes an inorganic material, and
   the fourth coating film includes a polymer compound having hydrophobic characteristics and including fluorine (F) and silicon (Si).
24. The inkjet head of any of clauses 13 to 23, wherein the nozzle plate includes polyimide (PI).
25. The inkjet head of any of clauses 13 to 24, wherein the piezoelectric plate includes:
   a first polymer layer disposed on the nozzle plate;
   an organic layer disposed on the first polymer layer;
   a piezoelectric member disposed on the organic layer;
   a metal layer disposed on the piezoelectric member;
   a glass layer disposed on the metal layer; and
   a second polymer layer disposed on the glass layer and the organic layer.
26. The inkjet head of any of clauses 13 to 25, wherein in case that the ink is disposed inside the inkjet head, a brightness ratio of a first area of the inkjet head where each of the nozzles is disposed in a second area of the inkjet head excluding the nozzles is about 1 or less.
27. A method of inspecting an inkjet head, the method comprising:
   manufacturing the inkjet head including:
      a nozzle plate including an organic material and including a plurality of nozzles that discharge an ink to an outside;
      a piezoelectric plate formed on the nozzle plate;
      a first coating film formed on a lower surface of the nozzle plate;
      a second coating film covering the first coating film and including a material different from the first coating film;
      a third coating film formed under the second coating film, covering at least a portion of the second coating film, and including an inorganic material; and
      a fourth coating film formed under the third coating film and including a material different from the first, second, and third coating films; and
   imaging the inkjet head as a two dimensional (2D) image in case that the ink is disposed inside the inkjet head.
28. The method of clause 27, wherein
   the imaging of the inkjet head as the 2D image in case that the ink is disposed inside the inkjet head includes:
   measuring an amount of gray level change between a first area of the inkjet head where each of the nozzles is disposed and a second area of the inkjet head excluding the nozzles.
29. The method of clause 27 or 28, wherein in case that the ink is disposed inside the inkjet head, a brightness ratio of a first area of the inkjet head where each of the nozzles is disposed in a second area of the inkjet head excluding the nozzles is about 1 or less.
30. The method of any of clauses 27 to 29, wherein in the imaging of the inkjet head as the 2D image in case that the ink is disposed inside the inkjet head,
   the inkjet head is imaged using a microscope in reflection mode or transmission mode.

## Claims

1. A method of manufacturing an inkjet head, the method comprising:
forming a preliminary nozzle plate including an organic material;
forming a nozzle plate including a plurality of nozzles formed by processing the preliminary nozzle plate using a laser;
forming a piezoelectric plate on the nozzle plate;
forming a first coating film on a lower surface of the nozzle plate;
forming a second coating film covering the first coating film and including a material different from the first coating film;
forming a third coating film including a material different from the first and second coating films and disposed under the second coating film; and
forming a fourth coating film including a material different from the first, second, and third coating films and disposed under the third coating film.

2. The method of claim 1, wherein at least one of:
in the forming of the first coating film, the first coating film is formed to entirely cover an inner surface of the nozzle plate exposed by each of the nozzles; and/or
in the forming of the second coating film, the second coating film is formed to entirely cover a side surface of the piezoelectric plate.

3. The method of claim 1 or claim 2, wherein
the first coating film includes an organic material and an inorganic material,
the second coating film includes at least one of a metal oxide and an organic-inorganic composite material including the metal oxide,
the third coating film includes an inorganic material, and
the fourth coating film includes a polymer compound having hydrophobic characteristics and including fluorine (F) and silicon (Si).

4. The method of any preceding claim, wherein the preliminary nozzle plate includes polyimide (PI).

5. The method of any preceding claim, wherein the forming of the piezoelectric plate includes:
forming a first polymer layer on the nozzle plate;
forming an organic layer on the first polymer layer;
forming a piezoelectric member on the organic layer;
forming a metal layer on the piezoelectric member;
forming a glass layer on the metal layer; and
forming a second polymer layer on the glass layer and the organic layer.

6. The method of any preceding claim, comprising:
forming a preliminary first-first coating film on a lower surface of the preliminary nozzle plate;
forming a preliminary sacrificial coating film including a material different from the preliminary first-first coating film on a lower surface of the preliminary first-first coating film;
forming the nozzle plate including the plurality of nozzles, a first-first coating film of the first coating film forming a step with the nozzle plate, and a sacrificial coating film forming a step with the nozzle plate by processing the preliminary nozzle plate, the preliminary first-first coating film, and the preliminary sacrificial coating film using a laser;
removing the sacrificial coating film;
forming a first-second coating film of the first coating film covering the first-first coating film on a lower surface of the first-first coating film;
forming the second coating film covering the first-second coating film and including a material different from the first-first and first-second coating films;
forming the third coating film including a material different from the first-second and second coating films under the second coating film; and
forming the fourth coating film including a material different from the first-second, second, and third coating films under the third coating film.

7. An inkjet head comprising:
a nozzle plate including an organic material and including a plurality of nozzles that discharge an ink to an outside;
a piezoelectric plate disposed on the nozzle plate;
a first coating film disposed on a lower surface of the nozzle plate and an inner surface of the nozzle plate exposed by each of the nozzles;
a second coating film covering the first coating film and including a material different from the first coating film;
a third coating film disposed under the second coating film, covering at least a portion of the second coating film, and including a material different from the first and second coating films; and
a fourth coating film disposed under the third coating film and including a material different from the first, second, and third coating films.

8. The inkjet head of claim 7, wherein a first thickness of a portion of the first coating film contacting the lower surface of the nozzle plate is thicker than a second thickness of a portion of the first coating film contacting the inner surface of the nozzle plate.

9. The inkjet head of claim 7 or claim 8, wherein the third coating film extends from under the second coating film to at least a portion of an inside of the nozzles.

10. The inkjet head of any of claims 7 to 9, wherein
the inner surface of the nozzle plate includes a first side surface perpendicular to the lower surface of the nozzle plate and a second side surface inclined in a direction away from each of the nozzles, and
the third coating film extends from under the second coating film to an inside of the nozzles to face the first side surface of an inner surface of the nozzle plate.

11. The inkjet head of any of claims 7 to 10, wherein the first coating films includes:
a first-first coating film disposed on the lower surface of the nozzle plate and forming a step together with the nozzles plate; and
a first-second coating film disposed on a lower surface of the first-first coating film and the inner surface of the nozzle plate to cover the first-first coating film,
and optionally wherein a first thickness of a portion of the first coating film contacting the lower surface of the nozzle plate is thicker than a second thickness of a portion of the first coating film contacting the inner surface of the nozzle plate.

12. The inkjet head of any of claims 7 to 11, wherein
an average thickness of the first coating film is in a range of about 5 nm to about 25 nm, and/or
an average thickness of the second coating film is in a range of about 5 nm to about 1000 nm, and/or
an average thickness of the third coating film is in a range of about 5 nm to about 1000 nm;
and/or an average thickness of the fourth coating film is in a range of from about 20 nm or less.

13. The inkjet head of any of claims 7 to 12, wherein
the first coating film includes an organic material and an inorganic material,
the second coating film includes at least one of a metal oxide and an organic-inorganic composite material including the metal oxide,
the third coating film includes an inorganic material, and
the fourth coating film includes a polymer compound having hydrophobic characteristics and including fluorine (F) and silicon (Si).

14. The inkjet head of any of claims 7 to 13, wherein in case that the ink is disposed inside the inkjet head, a brightness ratio of a first area of the inkjet head where each of the nozzles is disposed in a second area of the inkjet head excluding the nozzles is about 1 or less.

15. A method of inspecting an inkjet head, the method comprising:
manufacturing the inkjet head including:
a nozzle plate including an organic material and including a plurality of nozzles that discharge an ink to an outside;
a piezoelectric plate formed on the nozzle plate;
a first coating film formed on a lower surface of the nozzle plate;
a second coating film covering the first coating film and including a material different from the first coating film;
a third coating film formed under the second coating film, covering at least a portion of the second coating film, and including an inorganic material; and
a fourth coating film formed under the third coating film and including a material different from the first, second, and third coating films; and
imaging the inkjet head as a two dimensional (2D) image in case that the ink is disposed inside the inkjet head.

16. The method of claim 15, wherein
the imaging of the inkjet head as the 2D image in case that the ink is disposed inside the inkjet head includes:
measuring an amount of gray level change between a first area of the inkjet head where each of the nozzles is disposed and a second area of the inkjet head excluding the nozzles.

17. The method of claim 15 or claim 16, wherein in the imaging of the inkjet head as the 2D image in case that the ink is disposed inside the inkjet head,
the inkjet head is imaged using a microscope in reflection mode or transmission mode.
